# EUROPEAN PATENT APPLICATION

(11) **EP 2 575 265 A1**
(43) Date of publication of application: **03.04.2013**
(21) Application number: 12005708.8
(22) Date of filing: 06.08.2012
(51) Int. Cl.: H04B 5/00

(54) **Shaped controlling signals in near field communications (NFC) devices**

(30) Priority: 30.09.2011 US 201113250321
(71) Applicant: Broadcom Corporation, Irvine, CA 92617 (US)
(72) Inventor: Clarke, David, Swindon, Wiltshire, SN26 7BB (GB)
(74) Representative: Jehle, Volker Armin

(57) **Abstract**

A near field communication (NFC) device operating in a tag emulator mode, including a controller to output a control signal to control operation of a transistor, a waveform shaper to shape the control signal and to generate a shaped signal by increasing a rise time and a fall time of the control signal, and the transistor to receive the shaped signal and to output a switching waveform to drive an antenna of the NFC device.

## Description

### BACKGROUND OF THE INVENTION

### Field of the Invention

The present invention relates to the design of a Tag block of an NFC (near field communication) device. Circuitry in the Tag block detects a magnetic field output by a Reader block included in another NFC device, and demodulates the magnetic field to establish communication with the Reader block included in the another NFC device.

### Background Art

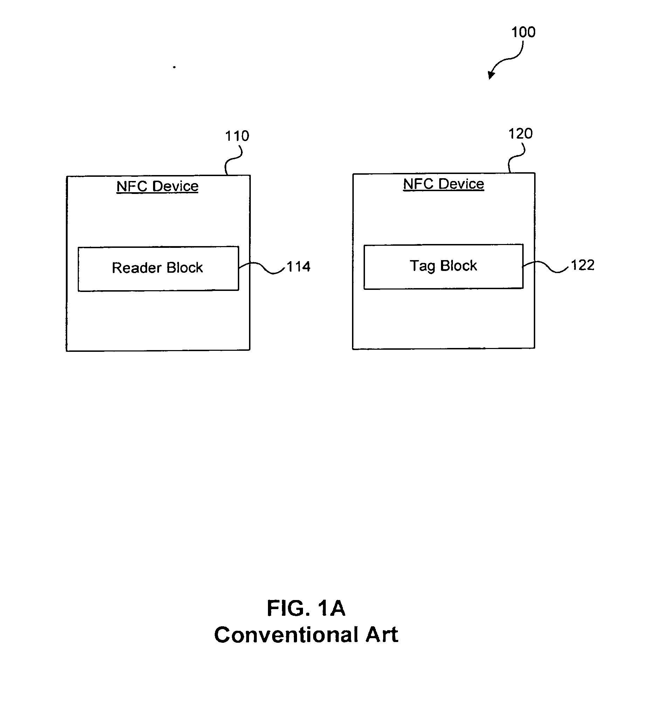

Fig. 1A shows a conventional communication system 100 including two NFC devices 110, 120 for communicating with each other. NFC device 110 includes a Reader block 114 and the NFC device 120 includes a Tag block 122, along with other supporting circuitry (not shown). The communication between the NFC devices 110, 120 is initiated when an antenna driver included in a Reader block drives an antenna of one of the NFC devices to output a magnetic field that can power a Tag block included in the other NFC device. The communication is established when the powered Tag block modulates the magnetic field with a communications signal and transmits the modulated signal to the Reader block. For example, to initiate communication, the Reader block 114 includes an antenna driver that drives an antenna associated with the NFC device 110 to output a magnetic field that powers the Tag block 122 included in the NFC device 120. The communication is established when the Tag block 122 is powered by the output magnetic field, and when Tag block 122 modulates the magnetic field with a communications signal and transmits the modulated signal back to Reader block 114.

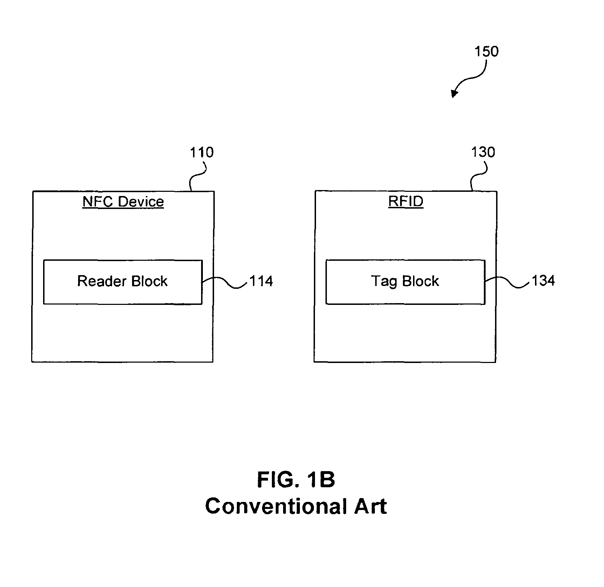

Alternatively, in the communication system 150 illustrated in Fig. 1B, the NFC device 110 may communicate with a Radio-Frequency Identification (RFID) device. The RFID device 130 includes a Tag 134 and other supporting circuitry (not shown). The communication between the NFC device 110 and the RFID device 130 is similar to the communication between the NFC device 110 and the NFC device 120 discussed above. In particular, to initiate communication, the Reader block 114 includes an antenna driver that drives an antenna associated with the NFC device 110 to output a magnetic field that powers the Tag block 134 included in the RFID device 130. The communication is established when the Tag block 134 is powered by the output magnetic field, and when Tag block 134 modulates the magnetic field with a communications signal and transmits the modulated signal back to Reader block 114. The RFID device 130 can be similar to a RFID device according to ISO 14443, ISO 15693, or a contactless RFID smart card. The NFC device 120 and the RFID 130 function in a tag emulator mode while communicating with the NFC device 110.

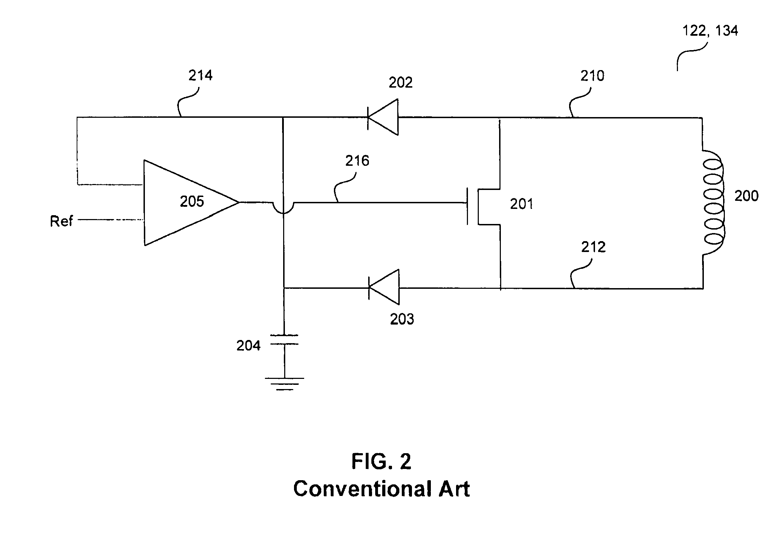

Fig. 2 shows a conventional topology of a Tag block included in the NFC devices 110, 120 or the RFID 130. In this conventional topology, the Tag block 122, 134 includes a linear shunt regulator. In particular, the Tag block 122, 134 includes an antenna 200, a field effect transistor (FET) 201, rectifying diodes 202, 203, a capacitor 203, and an error amplifier 205. The antenna 200 detects the output magnetic field and provides a differential pair of signals 210, 212, which are rectified by rectifying diodes 202, 203. The rectified output 214 is then compared by the error amplifier 205 with a reference signal (Ref). Based on the results of the comparison, the error amplifier 205 outputs signal 216 to adjust the operation of the FET 201, which is functioning as the shunt regulator. Upon receiving signal 216, the FET 201 regulates and clamps the waveform which drives the antenna 200. However, when the FET 201 regulates and clamps the waveform, the FET 201 dissipates a lot of energy (by sinking current) and thereby distorts the waveform. The distortion of the waveform which drives the antenna 200 results in undesired out-of band emissions which interfere with other peripheral radio communication. Therefore, in summary, the conventional topology of the Tag block 122, 134 using a linear shunt regulator is inefficient for dissipating a lot of power and results in undesirable out-of-band emission. The NFC device 110 may include a Tag block, and each of the NFC device 120 and the RFID device 130 may include a Reader block.

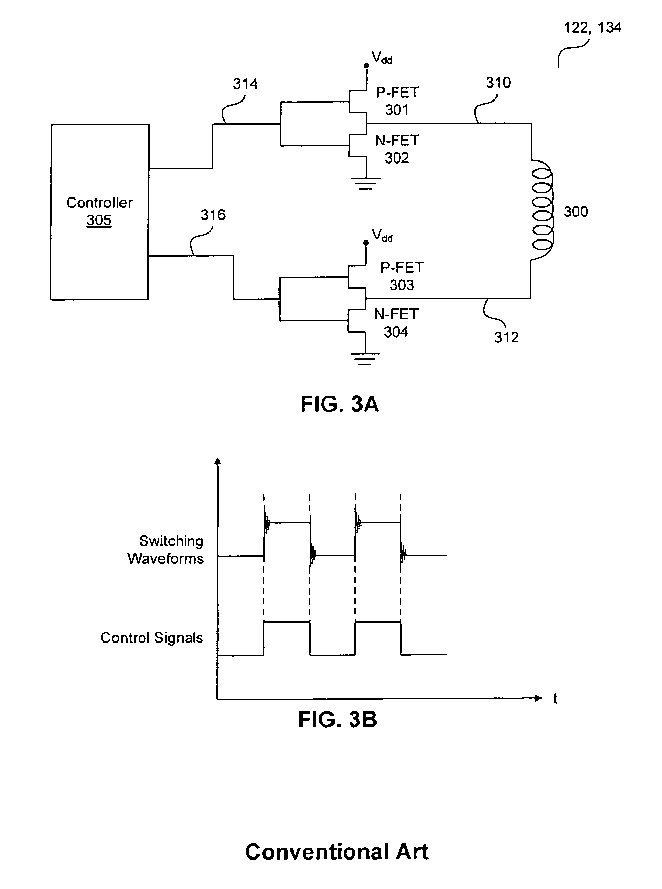

To resolve the inefficiencies of the conventional linear shunt topology shown in Fig. 2, it has been suggested that a class-D amplifier configuration be used to drive the antenna 200. This configuration is shown in Fig. 3A.

The class-D amplifier configuration includes an antenna 300, differential signals 310, 312, P-FETs 301, 303 and N-FETs 302, 304 connected in the class-D configuration, a controller 305, and other supporting circuitry (not shown). The P-FETs 301, 303 are connected to a source V_{DD} and the N-FETs 302, 304 are connected to ground. In this configuration, the FETs 301, 302, 303, 304 are switched on and off to output the switching waveform that drives the antenna 300. Since the FETs are switched on and off as opposed to linearly regulating a FET as shown in Fig. 2, this switching configuration is more efficient because is does not sink a lot of current. However, as shown in Fig. 3B, the switching on and off of the FETs 301, 302, 303, 304 using signals 314, 316 is very abrupt. This abrupt switching on and off significantly distorts the switching waveform which drives the antenna 300, and thereby exacerbates the out-of-band emissions.

In particular, as shown in Fig. 3B, the abrupt switching of signals 310, 312 causes overshoots and undershoots in the switching waveforms 310, 312 which drive the antenna 300. This is because of the variations in the average impedance across the antenna 300, leading to out-of-band emissions. Further, the harmonics of these overshoots and undershoots exacerbate the undesired out-of-band emissions. Therefore, the conventional class-D amplifier configuration is impractical because it exacerbates the undesired out-of-band emissions.

As such, there is a need for a solution which minimizes the undesired out-of-band emissions without dissipating a lot of power.

### BRIEF SUMMARY OF THE INVENTION

According to an aspect of the invention, a near field communication (NFC) device comprises:
a controller configured to output a control signal;
a waveform shaper configured to shape the control signal to provide a shaped signal by increasing a rise time and a fall time of the control signal; and
a transistor configured to output a switching waveform in response to the shaped signal to drive an antenna of the NFC device.

Advantageously, the waveform shaper comprises:
a first inverting amplifier configured to invert the control signal and to output an inverted signal;
a matched transistor configured to modulate the inverted signal in accordance with characteristics of the transistor; and
an inverse function circuit configured to carry out an inverse square function on the modulated inverted signal to generate the shaped signal.

Advantageously, the inverse function circuit comprises:
a second inverting amplifier configured to invert the modulated inverted signal and to generate the shaped signal; and
a multiplier is configured to perform a square function on the shaped signal, and to output a squared signal to the second inverting amplifier.

Advantageously, the waveform shaper is further configured to shape the control signal to minimize out-of-band emissions of the antenna.

Advantageously, the waveform shaper is further configured to shapethe control signal to minimize variations in the switching waveform.

According to an aspect, a method for minimizing undesired out-of-band emissions in a near field communication (NFC) device comprises:
providing, by the NFC device, a control signal;
shaping, by the NFC device, the control signal to generate a shaped signal by increasing a rise time and a fall time of the control signal; and
providing, by the NFC device, a switching waveform in response to theshaped signal to drive an antenna of the NFC device based on the shaped signal.

Advantageously, the shaping the control signal comprises:
inverting the control signal to output an inverted signal;
modulating the inverted signal in accordance with characteristics of the transistor; and
performing an inverse square function on the modulated inverted signal to generate the shaped signal.

Advantageously, the performing the inverse square function comprises:
inverting the modulated inverted signal to generate the shaped signal,
wherein the inverse square function is performed on the shaped signal, and a square signal is output to the second inverting amplifier via a feedback resistor.

Advantageously, the shaping shapes the control signal to minimize out-of-band emissions of the antenna.

Advantageously, the shaping shapes the control signal to minimize variations in the switching waveform.

### BRIEF DESCRIPTION OF THE DRAWINGS

The accompanying drawings, which are incorporated herein and form a part of the specification, illustrate the present invention and, together with the description, further serve to explain the principles of the invention and to enable a person skilled in the pertinent art to make and use the invention.

FIG. 1A illustrates a block diagram of a conventional communication system 100 including NFC devices 110, 120.

FIG. 1B illustrates a block diagram of a conventional communication system 150 including an NFC devices 110 and a RFID device 130.

FIG. 2 illustrates a block diagram of a conventional Tag block including a shunt regulator configuration in a NFC device 110, 120 or RFID device 130.

FIG. 3A illustrates a block diagram of a conventional Tag block including a class-D amplifier configuration in a NFC device 110, 120 or RFID device 130.

FIG. 3B illustrates a representation of input and output waveforms generated by the conventional Tag block illustrated in Fig. 3A.

FIG. 4A illustrates an exemplaryblock diagram of a Tag block according to an embodiment of the present invention.

FIG. 4B illustrates an exemplary representation of input and output waveforms generated by the Tag block illustrated in Fig. 4Aaccording to an embodiment of the present invention.

Fig. 5 illustrates an exemplary configuration of a waveform shaper according to an embodiment of the present invention

The present invention will be described with reference to the accompanying drawings. The drawing in which an element first appears is typically indicated by the leftmost digit(s) in the corresponding reference number.

### DETAILED DESCRIPTION

In the following description, numerous specific details are set forth in order to provide a thorough understanding of the invention. However, it will be apparent to those skilled in the art that the invention, including structures, systems, and methods, may be practiced without these specific details. The description and representation herein are the common means used by those experienced or skilled in the art to most effectively convey the substance of their work to others skilled in the art. In other instances, well-known methods, procedures, components, and circuitry have not been described in detail to avoid unnecessarily obscuring aspects of the invention.

References in the specification to "one embodiment," "an embodiment," "an example embodiment," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to effect such feature, structure, or characteristic in connection with other embodiments whether or not explicitly described.

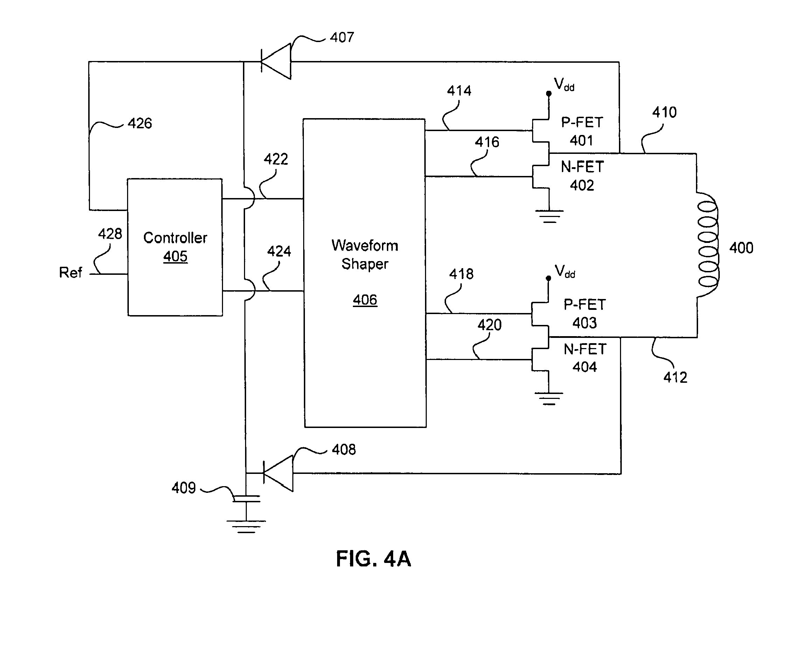

As discussed above, the conventional configurations of the Tag block 122, 134 are unable to minimize the undesired out-of-band emissions without dissipating a lot of power. The present invention minimizes the undesired out-of-band emissions without dissipating a lot of power, as shown in Fig. 4A.

The inventive configuration of the Tag block includes an antenna 400 having differential signals 410, 412, P-FETs 401, 403 and N-FETs 402, 404 forming the class-D amplifier configuration, shaped signals 414, 416, 418, 420, the waveform shaper 406, controller signals 422, 424, the controller 405, rectifying diodes 407, 408 to output a rectified signal 426, and a capacitor 409.

The antenna 400 detects the magnetic field output by a Reader block of another NFC device, and provides differential signals 410, 412. These differential signals 410, 412 are rectified by rectifying diodes 407, 408 to produce the rectified signal 426. The rectified signal 426 is received by the controller and compared to a reference signal 428. The reference signal is associated with a strength of the magnetic field detected by the antenna 400. In particular, the controller 405 compares the rectified signal 426 with the reference signal to determine a desired peak-to-peak voltage of the switching waveform that drives the antenna 400. This determination assists in modulating the phase and/or the amplitude and/or the frequency of the carrier of the detected magnetic field in accordance with the measured strength of the detected magnetic field. Based on the results of the comparison, the controller 405 outputs a set of controller signals 422, 424 to turn on and off the FETs 401, 402, 403, 404. The controller signals 422, 424 are generated as PWM signals having desired pulse widths (duty cycle) based on the strength of the magnetic field detected by the antenna 400. Further, controller signals 422, 424 are mirror images of each other.

The controller signals 422, 424 are provided to the waveform shaper 406. The waveform shaper 406 processes the controller signals 422, 424 (as discussed below) to generate shaped signals 414, 416, 418, 420, which turn on and off the FETs 401, 402, 403, 404 respectively. Now, because the signals which turn on and off the FETs are shaped, these signals linearly turn on and linearly turn off the FETs. In other words, the class-D amplifier FETs 401, 402, 403, 404 are smoothly turned on and off, thereby eliminating the abrupt switching on and off of the same. In one embodiment, the waveform shaper 406 shapes the control signals by increasing a rise time and a fall time of the control signal. As one can appreciate, the undesired overshoots and undershoots do not occur due to elimination of the abrupt switching.

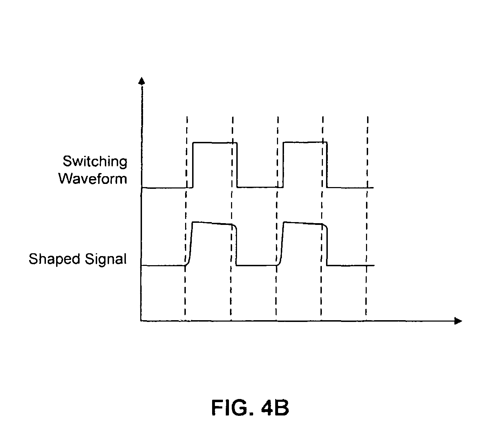

Fig. 4B shows an exemplary graph of the effect of the shaped signals on the switching waveform which drives the antenna 400.As shown in Fig. 4B, the shaped signals 414, 416, 418, 420 enable the FETs 401, 402, 403, 404 to turn on and off smoothly. This results in an equivalent transition of the switching waveform which drives the antenna 400. As such, the undesired overshoots and undershoots, and the resulting undesired out-of-band emissions, are minimized and/or eliminated. In this way, the present invention enables the minimization of the undesired out-of-band emissions without dissipating a lot of power.

Now, the process/method of driving the antenna 400 starts with providing the controller signals 422, 424 to the waveform shaper 406. In particular, control signal 422 is provided to control the P-FET 401 and N-FET 402, and the control signal 424 is provided to control P-FET 403 and N-FET 404.

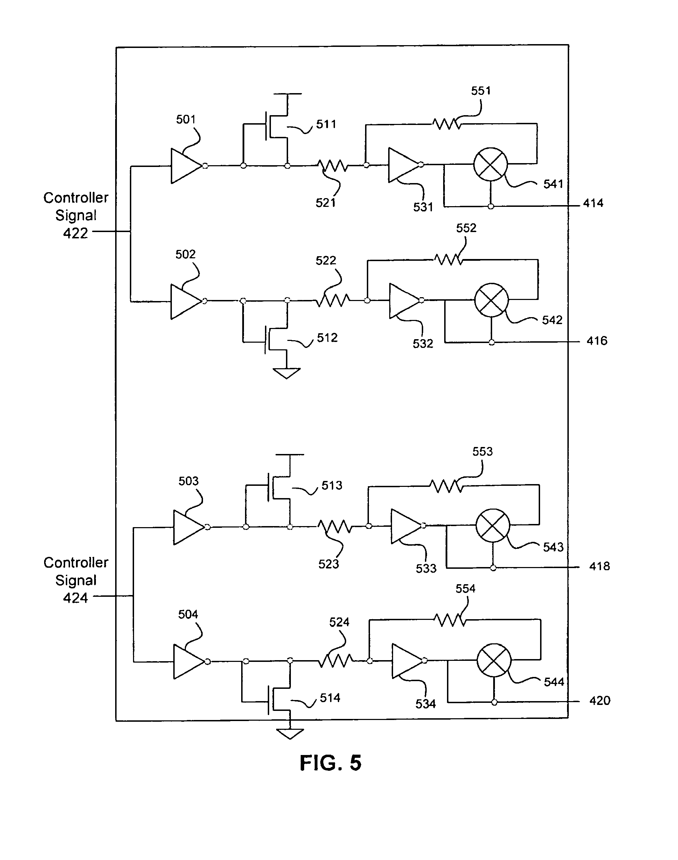

Fig. 5 shows an exemplary configuration of the waveform shaper 406 according to an embodiment of the present invention. The waveform shaper 406 includes inverting amplifiers 501, 502, 503, 504 (shown as inverting gates for simplicity), P-FETs 511, 513, N-FETs 512, 514, resistors 521, 522, 523, 524, inverting amplifiers 531, 532, 533, 534(shown as inverting gates for simplicity), multipliers 541, 542, 543, 544, and feedback resistors 551, 552, 553, 554.

The controller signal 422 is provided as the input to inverting amplifiers 501, 502. The outputs of the inverting amplifiers are provided to FETs 511, 512 to generate a voltage waveform based on a process and/or voltage and/or temperature match with respect to the FET 401, 402 whose operation is being controlled by the respective shaped signal 414, 416. The FETs 511, 512 modulate the output of the inverting amplifiers 501, 502, to generate voltage waveforms in accordance with the type of FETs 401, 402 being controlled. For example, because shaped signal 414 controls the P-FET 401, FET 511 used to generate shaped signal 414 should be a P-FET. Likewise, because shaped signal 416 controls N-FET 402, FET 512 used to generate shaped signal 416 should be an N-FET.

The signals generated by the FETs 511, 512 are input to inverting amplifiers 531, 532. The outputs of the inverting amplifiers 531, 532 are provided to multipliers 541, 542 respectively. The multipliers multiply the outputs of the inverting amplifiers 531, 532 with the outputs themselves to generate square functions of the same. The square functions are then provided as inputs to inverting amplifiers 531, 532 via feedback resistors 551, 552. The inverting amplifiers then invert the square functions by performing a function inverse to a square function, and output shaped signals 414, 416 to smoothly turn on and off the switching FETs 401, 402.

Controller signal 424 is processed in a similar way to output shaped signals 418, 420 which smoothly turn on and off FETs 403, 404 respectively.

Therefore, by shaping the signals used to switch on and off the FETs that output the switching waveform to drive the antenna, undesired out-of-band emissions are minimized. The above inventive configuration of the Tag block including the waveform shaper allows co-existence of other radio communication around the Tag block.

Although, the description of the present invention is to be described in terms of NFC, those skilled in the relevant art(s) will recognize that the present invention may be applicable to other communications that use the near field and/or the far field without departing from the spirit and scope of the present invention. For example, although the present invention is to be described using NFC capable communication devices, those skilled in the relevant art(s) will recognize that functions of these NFC capable communication devices may be applicable to other communications devices that use the near field and/or the far field without departing from the spirit and scope of the present invention.

It is to be appreciated that the Detailed Description section, and not the Abstract section, is intended to be used to interpret the claims. The Abstract section may set forth one or more but not all exemplary embodiments of the present invention as contemplated by the inventor(s), and thus, is not intended to limit the present invention and the appended claims in any way.

The present invention has been described above with the aid of functional building blocks illustrating the implementation of specified functions and relationships thereof. The boundaries of these functional building blocks have been arbitrarily defined herein for the convenience of the description. Alternate boundaries can be defined so long as the specified functions and relationships thereof are appropriately performed.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description and not of limitation, such that the terminology or phraseology of the present specification is to be interpreted by the skilled artisan in light of the teachings and guidance.

It should be noted that any exemplary processes described herein can be implemented in hardware, software, or any combination thereof. For instance, an exemplary process described herein can be implemented using computer processors, computer logic, application specific circuits (ASICs), digital signal processors (DSP), etc., as will be understood by one of ordinary skill in the arts based on the discussion herein.

Moreover, the exemplary process can be embodied by a computer processor or any one of the hardware devices listed above. The computer program instructions cause the processor to perform the signal processing functions described herein. The computer program instructions (e.g., software) can be stored in a computer useable medium, computer program medium, or any storage medium that can be accessed by a computer or processor. Such media include a memory device such as a computer disk or CD ROM, or the equivalent. Accordingly, any computer storage medium having computer program code that causes a processor to perform the functions described herein are with the scope and spirit of the present invention.

The breadth and scope of the present invention should not be limited by any of the above-described exemplary embodiments, but should be defined only in accordance with the following claims and their equivalents.

## Claims

1. A near field communication (NFC) device, comprising:
a controller configured to output a control signal;
a waveform shaper configured to shape the control signal to provide a shaped signal by increasing a rise time and a fall time of the control signal; and
a transistor configured to output a switching waveform in response to the shaped signal to drive an antenna of the NFC device.

2. The NFC device according to claim 1, wherein the waveform shaper comprises:
a first inverting amplifier configured to invert the control signal and to output an inverted signal;
a matched transistor configured to modulate the inverted signal in accordance with characteristics of the transistor; and
an inverse function circuit configured to carry out an inverse square function on the modulated inverted signal to generate the shaped signal.

3. The NFC device according to claim 2, wherein the inverse function circuit comprises:
a second inverting amplifier configured to invert the modulated inverted signal and to generate the shaped signal; and
a multiplier is configured to perform a square function on the shaped signal, and to output a squared signal to the second inverting amplifier.

4. The NFC device according to claim 1, wherein the waveform shaper is further configured to shape the control signal to minimize out-of-band emissions of the antenna.

5. The NFC device according to claim 1, wherein the waveform shaper is further configured to shapethe control signal to minimize variations in the switching waveform.

6. A method for minimizing undesired out-of-band emissions in a near field communication (NFC) device, comprising:
providing, by the NFC device, a control signal;
shaping, by the NFC device, the control signal to generate a shaped signal by increasing a rise time and a fall time of the control signal; and
providing, by the NFC device, a switching waveform in response to theshaped signal to drive an antenna of the NFC device based on the shaped signal.

7. The method according to claim 6, wherein the shaping the control signal comprises:
inverting the control signal to output an inverted signal;
modulating the inverted signal in accordance with characteristics of the transistor; and
performing an inverse square function on the modulated inverted signal to generate the shaped signal.

8. The method according to claim 7, wherein the performing the inverse square function comprises:
inverting the modulated inverted signal to generate the shaped signal,
wherein the inverse square function is performed on the shaped signal, and a square signal is output to the second inverting amplifier via a feedback resistor.

9. The method according to claim 6, wherein the shaping shapes the control signal to minimize out-of-band emissions of the antenna.

10. The method according to claim 6, wherein the shaping shapes the control signal to minimize variations in the switching waveform.
